# EUROPÄISCHE PATENTSCHRIFT

(11) **EP 3 369 116 B1**
(45) Veröffentlichungstag und Bekanntmachung des Hinweises auf die Patenterteilung: **01.12.2021**
(21) Anmeldenummer: 16763222.3
(22) Anmeldetag: 29.08.2016
(51) Int. Cl.: H01L 29/78

(54) **LEISTUNGS-MOSFET**
POWER MOSFET
TRANSISTOR MOSFET

(30) Priorität: 28.10.2015 DE 102015221054
(43) Veröffentlichungstag der Anmeldung: 05.09.2018
(73) Patentinhaber: Robert Bosch GmbH, 70442 Stuttgart (DE)
(72) Erfinder: GOERLACH, Alfred, 72127 Kusterdingen (DE)
(86) Internationale Anmeldenummer: PCT/EP2016/070330
(87) Internationale Veröffentlichungsnummer: WO 2017/071855

(56) Entgegenhaltungen:
- EP-A1- 0 580 452
- JP-A- 2002 270 841
- US-A1- 2005 167 695
- US-A1- 2012 261 676

## Beschreibung

### Stand der Technik

Die Erfindung betrifft einen Leistungs-Metall-Oxid-Halbleiter-Feldeffektransistor MOSFET.

### Stand der Technik

Das Dokument US 2005 / 167 695 A1 beschreibt ein Halbleiterbauelement mit dielektrisch isoliertem pn-Übergang für verbesserte Durchbruchseigenschaften. Im Unterschied zum beanspruchten Leistungs-MOSFET offenbart dieses Dokument nicht, dass zwischen der Epischicht und der Siliziumschicht eine Zwischenschicht angeordnet ist, die eine höhere Dotierung aufweist als die Epischicht, wobei die Zwischenschicht ein siebtes Dotiergebiet aufweist, das den ersten Leitfähigkeitstyp aufweist, wobei ein unmittelbarer Kontakt der zweiten Gräben und der Zwischenschicht einen p/n-Übergang ergibt und auch nicht dass das kristalline Silicium in den zweiten Gräben (425) polykristallin ist. Stattdessen wird in diesem Dokument beschrieben, dass das Gebiet in den zweiten Gräben epitaktisch gewachsen wird.

Das Dokument EP 0508 452 A1 offenbart einen Feldeffekt-Grabentransistor mit leicht dotiertem Epitaxiebereich auf dessen Oberflächenbereich.

Das Dokument US 2012 / 261 676 A1 beschreibt einen Feldeffekttransistor aus Siliziumkarbid.

Das Dokument JP 2002270841 beschreibt ein Halbleiterbauelement und ein Herstellungsverfahren für dasselbe.

Leistungs-MOSFETs werden in der Leistungselektronik als schnelle Schalter eingesetzt. Neben planaren, doppelt diffundierten Strukturen werden hauptsächlich Leistungs-MOSFETs mit Grabenstrukturen verwendet. Im Anwendungsfall weist der Drainanschluss ein positives Potential auf und der Sourceanschluss liegt auf Masse. Liegt bezogen auf den Sourceanschluss eine ausreichend positive Gatespannung an, bildet sich im Bodygebiet an der Grenzfläche zum Gateoxid ein dünner Elektroneninversionskanal. Dieser Elektroneninversionskanal erstreckt sich vom Sourceanschluss bis zu einer

Epischicht, sodass der Leistungs-MOSFET leitet. Wird das Drainpotential erhöht, bildet sich eine Raumladungszone aus, die sich vor allem ausgehend von den Grabenböden in die Epischicht erstreckt. Das bedeutet die höchste Feldstärke befindet sich in der Nähe der Grabenböden. Wird die Drainspannung weiter erhöht, steigt die Feldstärke in der Epischicht weiter an, sodass ein Avalanchedurchbruch stattfindet. Dabei wird ein hoher Stromfluss erzeugt, sodass die Drainspannung begrenzt wird.

Nachteilig ist hierbei, dass Minoritätsladungsträger, die durch den Avalanchedurchbruch erzeugt werden, durch die hohe Feldstärke in das Gateoxid injiziert werden. Dies erzeugt im Gateoxid fest eingebaute positive

Ladungen, wodurch die Eigenschaften des Leistungs-MOSFETs verändert bzw. dauerhaft geschädigt werden. Durch diese Veränderungen im Leistungs-MOSFET wird beispielsweise die Thresholdspannung reduziert.

Für einige Anwendungen in der Leistungselektronik ist es jedoch notwendig, den Leistungs-MOSFET im Avalanchedurchbruch zu betreiben. Auf diese Weise können Spannungsspitzen des Systems begrenzt werden und aufwendige Schutzschaltungen wären nicht notwendig.

Die Aufgabe der Erfindung besteht darin, einen langzeitstabilen Leistungs-MOSFET bereitzustellen, der im Avalanchedurchbruch betrieben werden kann.

### Offenbarung der Erfindung

Der erfindungsgemäße Leistungs- MOSFET ist im Anspruch 1 definiert.

Der Leistungs-MOSFET umfasst ein Substrat, das eine Substratoberfläche aufweist in die eine Grabenstruktur eingebracht ist. Erfindungsgemäß bilden eine Anzahl erster Gräben und eine Anzahl zweiter Gräben die Grabenstruktur. Dabei sind erste Gräben und zweite Gräben abwechselnd nebeneinander benachbart angeordnet. Das bedeutet neben einem ersten Graben ist ein zweiter Graben angeordnet, neben dem wiederum ein weiterer erster Graben angeordnet ist und neben dem wiederum ein weiterer zweiter Graben angeordnet ist, etc. Die Anzahl der ersten Gräben und der zweiten Gräben ist dabei beliebig. Die ersten Gräben sind mindestens teilweise mit einem ersten Material verfüllt. Die zweiten Gräben sind mit einem zweiten Material verfüllt. Das erste Material weist dabei einen ersten Leitfähigkeitstyp auf und das zweite Material einen zweiten Leitfähigkeitstyp. Der erste Leitfähigkeitstyp ist vom zweiten Leitfähigkeitstyp verschieden bzw. unterschiedlich.

Der Vorteil ist hierbei, dass der Sperrspannungsdurchbruch bzw.

Avalanchedurchbruch am Boden der zweiten Gräben stattfindet, sodass die erzeugten Minoritätsladungsträger direkt zum Sourceanschluss abgeleitet werden ohne dass eine nennenswerte schädliche Injektion der Minoritätsladungsträger in das Gateoxid erfolgt. Dadurch bleiben die Durchbruchspannung und die Thresholdspannung stabil, sodass der Leistungs-MOSFET langzeitstabil ist und ohne Performanceeinbußen im Avalanchedurchbruch betrieben werden kann.

Außerdem umfasst das Substrat mindestens eine Sourceschicht, eine Bodyschicht, eine Epischicht und eine Siliziumschicht. Diese Schichten sind übereinander angeordnet. Das bedeutet, die Sourceschicht ist unmittelbar auf der Bodyschicht, die Bodyschicht unmittelbar auf der Epischicht und die Epischicht auf der Siliziumschicht angeordnet. Unter dem Begriff Sourceschicht versteht sich hierbei eine Schicht, die mit einem Sourceanschluss verbindbar bzw. verbunden ist. Die Sourceschicht umfasst ein drittes Material, die Epischicht ein fünftes Material und die Siliziumschicht ein sechstes Material, wobei das dritte Material, das fünfte Material und das sechste Material den ersten Leitfähigkeitstyp aufweisen. Die Bodyschicht umfasst ein viertes Material, wobei das vierte Material den zweiten Leitfähigkeitstyp aufweist. Die ersten Gräben und die zweiten Gräben reichen mindestens bis in die Epischicht.

Vorteilhaft ist hierbei, dass der Leistungs-MOSFET im Durchbruchbereich mit hohen Strömen betrieben werden kann.

Darüber hinaus ist zwischen der Epischicht und der Siliziumschicht eine Zwischenschicht angeordnet, die eine höhere Dotierung aufweist als die Epischicht. Die Zwischenschicht umfasst ein siebtes Material, das den ersten Leitfähigkeitstyp aufweist.

Der Vorteil ist hierbei, dass die Dotierung dieser Schicht beim Herstellungsprozess besonders genau eingestellt werden kann. Dies ist insbesondere dann der Fall, wenn diese Zwischenschicht mittels Ionenimplantation erzeugt wird. Infolgedessen weist die Durchbruchsspannung nur eine geringe Schwankungsbreite auf.

Die zweiten Gräben reichen mindestens bis in die Zwischenschicht hinein.

Vorteilhaft ist hierbei, dass sich die Durchbruchspannung einstellen lässt und nur sehr geringe Schwankungen aufweist.

In einer weiteren Ausgestaltung ist die Siliziumschicht auf einer ersten Metallschicht angeordnet, die als Rückseitenmetallisierung fungiert.

Der Vorteil ist hierbei, dass ein Drainanschluss auf einfache Weise bereitgestellt wird.

In einer Weiterbildung ist der erste Leitfähigkeitstyp eine n-Dotierung und der zweite Leitfähigkeitstyp eine p-Dotierung.

In einer weiteren Ausgestaltung weisen die zweiten Gräben eine größere Breite auf als die ersten Gräben.

Vorteilhaft ist hierbei, dass sich die breiteren Gräben mit demselben Prozessschritt herstellen lassen wie die ersten Gräben.

In einer Weiterbildung weist das zweite Material Bor-Ionen auf.

Der Vorteil hierbei ist, dass das zweite Material in den zweiten Gräben auf einfache Weise eingebracht werden kann und einen pn-Übergang mit dem fünften bzw. siebten Material bildet.

In einer weiteren Ausgestaltung ist die Konzentration der Bor-Ionen an der Oberfläche der zweiten Gräben größer als 10¹⁸ cm⁻³.

Vorteilhaft ist hierbei, dass die zweiten Gräben mit einem Kontaktmetall bzw. - silizid einen Ohmschen Kontakt ausbilden.

Das Verfahren zur Herstellung eines Leistungs-MOSFETs mit Grabenstruktur umfasst das Erzeugen erster Gräben, das Erzeugen zweiter Gräben, wobei die ersten Gräben und die zweiten Gräben die Grabestruktur bilden und die ersten Gräben und die zweiten Gräben alternierend angeordnet sind. Die ersten Gräben werden teilweise mit einem ersten Material verfüllt, das einen ersten Leitfähigkeitstyp aufweist. Die zweiten Gräben werden mit einem zweiten Material verfüllt, das einen zweiten Leitfähigkeitstyp aufweist, wobei der erste Leitfähigkeitstyp und der zweite Leitfähigkeitstyp unterschiedlich sind.

Es wird auf der Grabenoberfläche der ersten Gräben eine dielektrische Schicht erzeugt, insbesondere mittels thermischer Oxidation.

In einer Weiterbildung wird ein Temperschritt mit einer Temperatur im Bereich zwischen 850°C und 1000°C und einer Zeitdauer von 30 Sekunden bis drei Minuten.

Weitere Vorteile ergeben sich aus der nachfolgenden Beschreibung von Ausführungsbeispielen bzw. aus den abhängigen Patentansprüchen.

### Kurze Beschreibung der Zeichnungen

Die vorliegende Erfindung wird nachfolgend anhand bevorzugter Ausführungsformen und beigefügter Zeichnungen erläutert. Es zeigen:
- Figur 1: einen Leistungs-MOSFET aus dem Stand der Technik,
- Figur 2: eine erste Ausführung eines nicht beanspruchten Leistungs-MOSFETs,
- Figur 3: eine Ausführung des erfindungsgemäßen Leistungs-MOSFETs und
- Figur 4: ein Verfahren zur Herstellung des erfindungsgemäßen Leistungs-MOSFETs.

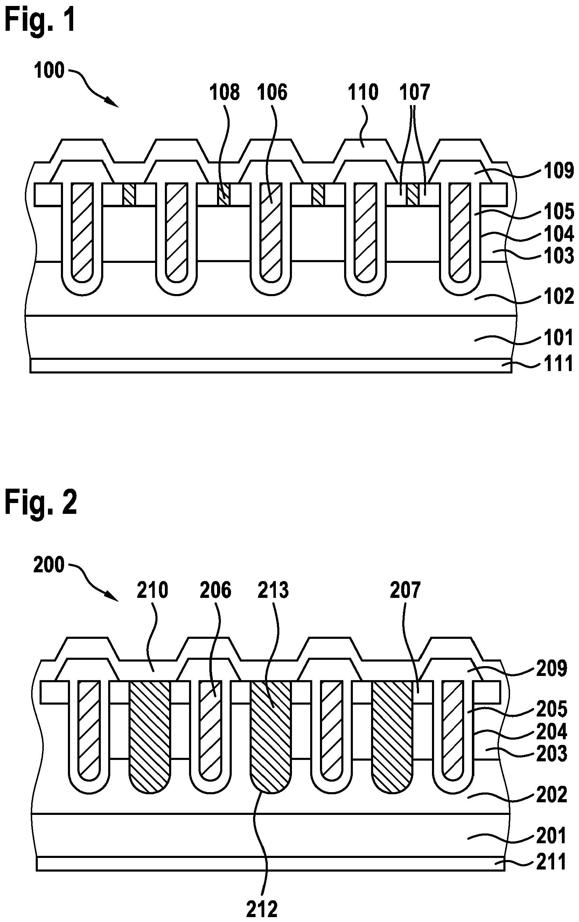

Figur 1 zeigt einen Leistungs-MOSFET 100 mit einer Grabenstruktur aus dem Stand der Technik. Dabei weist der Leistungs-MOSFET ein Substrat mit einer Substratoberfläche auf, wobei das Substrat aus einer Sourceschicht 107, einer Bodyschicht 103, einer Epischicht 102 und einer Siliziumschicht 101 besteht. Die Sourceschicht 107 und die Siliziumschicht 101 sind n⁺-dotiert, die Bodyschicht ist p-dotiert und die Epischicht 102 ist n-dotiert. In die Sourceschicht 107 sind hochdotierte p⁺-Bereiche 108 eingebracht, die einen Ohmschen Kontakt zur Bodyschicht ermöglichen. Die Grabenstruktur ist in die Substratoberfläche eingebracht. Die Gräben 104 reichen bis in die Epischicht 102. Auf der Grabenoberfläche ist eine erste dielektrische Schicht 105 angeordnet, die als Gateoxid fungiert. Die Gräben 104 sind beispielsweise mit einem n-dotierten polykristallinen Silizium verfüllt und bilden den Gateanschluss, wozu die Gräben 104 miteinander galvanisch verbunden sind. Der Gateanschluss ist in Figur 1 der Übersichtlichkeit halber nicht dargestellt. Er wird an der Substratoberfläche bzw. Oberseite des Leistungs-Mosfets herausgeführt. Die Siliziumschicht 101 ist auf einer ersten Metallschicht 111 angeordnet, die den Drainanschluss darstellt. Auf der Sourceschicht 107 ist eine strukturierte zweite dielektrische Schicht 109 angeordnet, die die Gräben 104 komplett verschließt, d. h. elektrisch isoliert. Auf der Sourceschicht 107 ist eine zweite Metallschicht 110 angeordnet, die mit der Sourceschicht 107 und den p⁺-dotierten Bereichen 108 unmittelbar elektrisch verbunden ist, sodass sich weiterere Ohmsche Kontakte bilden.

Figur 2 zeigt eine erste Ausführung eines nicht beanspruchten Leistungs-MOSFETs 200 mit einer Grabenstruktur. Der Leistungs-MOSFET 200 umfasst eine erste Metallschicht 211, eine Siliziumschicht 201, eine Epischicht 202, eine Bodyschicht 203, eine Sourceschicht 207, eine zweite dielektrische Schicht 209 und eine zweite Metallschicht 210. Die erste Metallschicht 211 fungiert dabei als Drainanschluss und die zweite Metallschicht 209 als Sourceanschluss. Das Substrat des Leistungs-MOSFETs 200 wird dabei von der Sourceschicht 207, der Bodyschicht 203, der Epischicht 202 und der Siliziumschicht 201 gebildet. Die Grabenstruktur ist in eine Substratoberfläche eingebracht, wobei die Substratoberfläche durch die Sourceschicht 207 gebildet wird. Die Grabenstruktur weist verschiedene Arten von Gräben auf, erste Gräben 204 und zweite Gräben 212, wobei die ersten Gräben 204 und die zweiten Gräben 212 abwechselnd nebeneinander angeordnet sind. Die ersten Gräben 204 umfassen auf der Grabenoberfläche eine erste dielektrische Schicht 205, die als Gateoxid fungiert. Die ersten Gräben 204 sind mit einem ersten Material 206 teilweise verfüllt. Mit anderen Worten zwischen dem ersten Material 206 und der Grabenoberfläche ist eine dünne Oxidschicht 205 angeordnet. Die ersten Gräben 2014 sind miteinander galvanisch verbunden, sodass das erste Material 206 den Gateanschluss formt. Der Gateanschluss ist auch in Figur 2 übersichtlichkeitshalber nicht zeichnerisch dargestellt. Das erste Material 206 weist dabei einen ersten Leitfähigkeitsyp auf. Die zweiten Gräben sind komplett mit einem zweiten Material 213 verfüllt. Das zweite Material 213 weist einen zweiten Leitfähigkeitstyp auf. Der erste Leitfähigkeitstyp und der zweite Leitfähigkeitstyp sind dabei unterschiedlich. Die ersten Gräben 204 sind durch die zweite dielektrische Schicht 209 von der zweiten Metallschicht 210 elektrisch isoliert. Das bedeutet die zweite dielektrische Schicht 209 verschließt die ersten Gräben 204.

Die erste dielektrische Schicht 205 umfasst beispielsweise Siliziumoxid einer Dicke im Bereich von 5 - 150 Nanometern, vorzugsweise 60 Nanometer. Die zweite dielektrische Schicht weist mindestens eine Höhe von 100 Nanometern auf, insbesondere einen Bereich von 100 - 2000 Nanometer, vorzugsweise im Wesentlichen 400 Nanometer. Die erste Metallschicht 211 umfasst ein lötfähiges Metall beispielsweise mit einer Schichtenfolge aus Cr, NiV und Ag. Die zweite Metallschicht 210 umfasst beispielsweise Aluminium. Das erste Material 206 und das zweite Material 213 umfassen polykristallines Silizium. Das erste Material 206 umfasst beispielsweise n-dotiertes polykristallines Silizium, das zweite Material 213 p-dotiertes polykristallines Silizium, das dritte Material 207 n⁺-dotiertes einkristallines Silizium, das vierte Material 203 p-dotiertes einkristallines Silizium, das fünfte Material 202 n-dotiertes einkristallines Silizium und das sechste Material 201 n⁺-dotiertes einkristallines Silizium.

Die Höhe der Dotierungskonzentrationen und Ausdehnungen der Bereiche hängen u. a. von der gewünschten Durchbruchsspannung des Leistungs-MOSFETs ab. Für einen MOSFET der 40V-Spannungsklasse weist das dritte hoch n⁺-dotierte Material 207 eine Konzentration größer als 10¹⁹ cm⁻³, das p-dotierte Material 203 eine Dotierung im Bereich von 10¹⁷ cm⁻³ und die Dotierung der Epischicht einige 10¹⁶ cm⁻³ auf. Das sechste Material soll möglichst hoch dotiert sein, beispielsweise 10²¹ cm⁻³ . Üblicherweise sind die Dotierprofile der Schichten 207 und 203 nicht konstant, sondern nehmen mit zunehmendem Abstand von der Oberfläche ab.

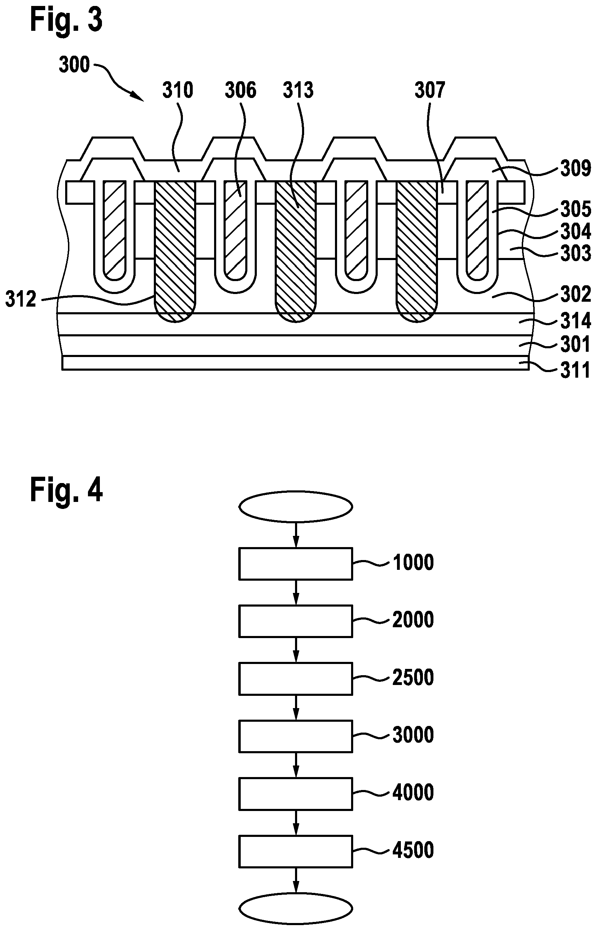

Figur 3 zeigt eine Ausführung des erfindungsgemäßen Leistungs-MOSFETs 300. Merkmale in Figur 3, die die gleiche Bedeutung haben wie in Figur 2 weisen dabei identische hintere Stellen der Bezugszeichen auf wie die Bezugszeichen in Figur 2. Der Leistungs-MOSFET 300 ist gegenüber dem Leistungs-MOSFET 200 dahingehend erweitert, dass zwischen der Epischicht 302 und der Siliziumschicht 301 eine Zwischenschicht 314 angeordnet ist. Die Zwischenschicht 314 umfasst ein siebtes Material, das den ersten Leitfähigkeitstyp aufweist. Dabei ist ihre Dotierung höher gewählt als die Dotierung der Epischicht 302 und niedriger als die Dotierung der Siliziumschicht 301. Die Zwischenschicht ist beispielsweise mit As, Sb oder Phosphor dotiert. Die zweiten Gräben 312 reichen bis in die Zwischenschicht 314. Dadurch erfolgt ein Avalanchedurchbruch des Leistungs-MOSFETs an einem p/n-Übergang, der sich aufgrund des unmittelbaren Kontakts der zweiten Gräben 312 und der Zwischenschicht 314 ergibt.

Der erste Leitfähigkeitstyp umfasst eine n-Dotierung und der zweite Leitfähigkeitstyp eine p-Dotierung. Alternativ umfasst der erste Leitfähigkeitstyp eine p-Dotierung und der zweite Leitfähigkeitstyp eine n-Dotierung.

Das zweite Material 213 und 313 ist beispielsweise mit Bor-Ionen dotiert.

In einem Ausführungsbeispiel weisen die zweiten Gräben 212 und 312 die gleiche Tiefe auf wie die ersten Gräben 204 und 304. Die ersten Gräben 204 und 304 und die zweiten Gräben 212 und 312 reichen bis in die Epischicht 202 und 302 hinein.

In einem weiteren Ausführungsbeispiel weisen die zweiten Gräben 212 und 312 eine größere Tiefe auf als die ersten Gräben 204 und 304. Die zweiten Gräben 212 und 312 reichen dabei bis in die Siliziumschicht 201 und 301. Dadurch erfolgt ein Avalanchedurchbruch des Leistungs-MOSFETs an einem p/n-Übergang zwischen den zweiten Gräben 212 und 312 und der Epischicht 202 und 302. Das bedeutet, die Sperrspannung ist abhängig von der Tiefe der verfüllten zweiten Gräben.

In einem weiteren Ausführungsbeispiel umfassen die ersten Gräben 204 und 304 jeweils eine Feldplatte, die unterhalb des ersten Materials 206 und 306 bzw. des eigentlichen Gates innerhalb der ersten Gräben 204 und 304 angeordnet ist. Die Feldplatte umfasst n-dotiertes polykristallines Silizium, das von einer Oxidschicht umgeben ist, deren Dicke größer ist als die des Gateoxids. Diese Oxidschicht isoliert die Feldplatte zum einen von dem eigentlichen Gate und zum anderen von der Epischicht 202 und 302 elektrisch.

In einem weiteren Ausführungsbeispiel ist das erste Material 206 und 306 mit der zweiten Metallschicht 210 und 310 elektrisch verbunden, sodass der MOSFET als Diode fungiert. Dabei bildet die erste Metallschicht 211 und 311 den Kathoden- und die zweite Metallschicht 210 und 310 den Anodenanschluss. Die Dicke der ersten dielektrischen Schicht 205 und 305 weist dabei maximal einen Wert von 15 Nanometern auf. Dadurch wird eine sehr geringe Schwellenspannung und damit eine niedrige Durchlassspannung der MOS-Diode erreicht.

In einem weiteren Ausführungsbeispiel ist das erste Material 106 und 206 galvanisch mit dem zweiten Material 212 und 312 und dem dritten Material 207 und 307 verbunden ist. Dabei beträgt die Dicke des Gateoxid 205 und 305 weniger als 15 Nanometer.

Figur 4 beschreibt ein Verfahren zur Herstellung eines Leistungs-MOSFETs mit einer Grabenstruktur. Das Verfahren startet mit einem Schritt 1000 in dem erste Gräben erzeugt werden. In einem folgenden Schritt 2000 werden zweite Gräben erzeugt, wobei die ersten Gräben und die zweiten Gräben die Grabenstruktur bilden. Die ersten Gräben und die zweiten Gräben sind alternierend nebeneinander angeordnet. In einem folgenden Schritt 2500 wird eine erste dielektrische Schicht auf der Grabenoberfläche der ersten Gräben, beispielsweise mittels thermischer Oxidation, erzeugt. In einem folgenden Schritt 3000 werden die ersten Gräben teilweise mit einem ersten Material verfüllt, wobei das erste Material einen ersten Leitfähigkeitstyp aufweist. In einem folgenden Schritt 4000 werden die zweiten Gräben vollständig mit einem zweiten Material verfüllt, wobei das zweite Material einen zweiten Leitfähigkeitstyp aufweist. Der erste Leitfähigkeitstyp und der zweite Leitfähigkeitstyp sind dabei unterschiedlich.

In einem Ausführungsbeispiel werden die zweiten Gräben, zeitlich vor Ausführung des Schritts 4000, gereinigt und thermisch oxidiert. Das sich dabei gebildete - beispielsweise 40 Nanometer dicke - Siliziumdiodxid wird anschließend vollständig entfernt. Dies kann durch einen naßchemischen Ätzprozess erfolgen. Mit anderen Worten es erfolgt eine temporäre Oxidation der zweiten Gräben nach einem Reinigungsschritt. Unmittelbar bzw. sofort danach, in Schritt 4000, werden die zweiten Gräben mit dem zweiten Material verfüllt. Dazu wird mit einem LPCVD Prozess Polysilizium bei Temperaturen von etwa 650°C abgeschieden und in situ-mit Bor-Ionen dotiert. Die Borkonzentration beträgt dabei ungefähr 5*10¹⁸ cm⁻³. Grundsätzlich kann die Bordotierung auch nach dem Verfüllen von undotiertem Polysilizium mittels Ionenimplantation erfolgen. In einem auf Schritt 4000 folgenden schnellen Temperschritt 4500 werden die Bor-Ionen aktiviert und es erfolgt eine geringfügige Diffusion in die Epischicht. Dieser Temperschritt bzw. Temperaturschritt ist auch als rapid thermal processing bekannt. Dazu wird beispielsweise eine Temperatur zwischen 850°C und 1000°C verwendet, vorzugsweise 900°C. Die Dauer des Temperaturschritts beträgt zwischen 30 Sekunden und drei Minuten. Auf diese Weise beträgt die Eindringtiefe der Bor-Ionen in die Epischicht ungefähr 25 nm - 200 nm. Durch diese vermeintlichen Verunreinigungen der n-dotierten Epischicht mit Bor wird ein nahezu idealer p/n-Übergang zwischen den zweiten Gräben und der Epischicht erzeugt.

## Patentansprüche

1. Leistungs-MOSFET (200, 300) mit einem Substrat, das eine Substratoberfläche aufweist in die eine Grabenstruktur eingebracht ist, wobei erste Gräben (204, 304) mit einem Gateoxid auf der Grabenoberfläche und zweite Gräben (212, 312) die Grabenstruktur bilden, indem die ersten Gräben (204, 304) und die zweiten Gräben (212, 312) alternierend angeordnet sind, die ersten Gräben (204, 304) mindestens teilweise mit einem einen Gateanschluss bildenden polykristallinen Silizium als erstes Dotiergebiet (206, 306) verfüllt sind und die zweiten Gräben (212, 312) mit polykristallinem Silizium als zweites Dotiergebiet (213, 313) verfüllt sind, wobei das polykristalline Silizium im ersten Graben (204, 304) einen ersten Leitfähigkeitstyp aufweist und das polykristalline Silizium im zweiten Graben (206, 306) einen zweiten Leitfähigkeitstyp aufweist, wobei der erste Leitfähigkeitstyp und der zweite Leitfähigkeitstyp unterschiedlich sind, wobei das Substrat mindestens eine Sourceschicht (207, 307), eine Bodyschicht (203, 303), eine Epischicht (202, 302) und eine Siliziumschicht (201, 301) umfasst, wobei die Sourceschicht (207, 307) unmittelbar auf der Bodyschicht (203, 303) angeordnet ist, die Bodyschicht (203, 303) unmittelbar auf der Epischicht (202, 302) angeordnet ist und die Epischicht (202, 302) auf der Siliziumschicht (201, 301) angeordnet ist, wobei die Sourceschicht (207, 307) ein drittes Dotiergebiet umfasst, die Epischicht (202, 302) ein fünftes Dotiergebiet umfasst und die Siliziumschicht (201, 301) ein sechstes Dotiergebiet umfasst, wobei das dritte Dotiergebiet, das fünfte Dotiergebiet und das sechste Dotiergebiet den ersten Leitfähigkeitstyp aufweisen und die Bodyschicht (203, 303) ein viertes Dotiergebiet umfasst, wobei das vierte Dotiergebiet den zweiten Leitfähigkeitstyp aufweist, wobei die ersten Gräben (204, 304) und die zweiten Gräben (212, 312) mindestens bis in die Epischicht (202, 302) hineinreichen, wobei zwischen der Epischicht (202, 302) und der Siliziumschicht (201, 301) eine Zwischenschicht (314) angeordnet ist, die eine höhere Dotierung aufweist als die Epischicht (202, 302), wobei die Zwischenschicht (314) ein siebtes Dotiergebiet aufweist, das den ersten Leitfähigkeitstyp aufweist, wobei ein unmittelbarer Kontakt der zweiten Gräben (212, 312) und der Zwischenschicht (314) einen p/n-Übergang ergibt.

2. Leistungs-MOSFET (200, 300) nach Anspruch 1, **dadurch gekennzeichnet, dass** die zweiten Gräben (212, 312) mindestens bis in die Zwischenschicht (314) hineinreichen.

3. Leistungs-MOSFET (200, 300) nach einem der Ansprüche 1 oder 2, **dadurch gekennzeichnet, dass** die Siliziumschicht (201, 301) auf einer ersten Metallschicht (211, 311) angeordnet ist, die als Rückseitenmetallisierung fungiert.

4. Leistungs-MOSFET (200, 300) nach einem der vorhergehenden Ansprüche, **dadurch gekennzeichnet, dass** der erste Leitfähigkeitstyp einer n-Dotierung entspricht und der zweite Leitfähigkeitstyp einer p-Dotierung entspricht.

5. Leistungs-MOSFET (200, 300) nach einem der vorhergehenden Ansprüche, **dadurch gekennzeichnet, dass** die zweiten Gräben (212, 312) eine größere Breite aufweisen als die ersten Gräben (204, 304).

6. Leistungs-MOSFET (200, 300) nach einem der vorhergehenden Ansprüche, **dadurch gekennzeichnet, dass** das zweite Material Bor-Ionen aufweist.

7. Leistungs-MOSFET (200, 300) nach Anspruch 6, **dadurch gekennzeichnet, dass** die Konzentration der Bor-Ionen an der Oberfläche der zweiten Gräben größer als 10¹⁸ cm⁻³ ist.

## Claims

1. Power MOSFET (200, 300) comprising a substrate having a substrate surface into which a trench structure is introduced, wherein first trenches (204, 304) with a gate oxide on the trench surface and second trenches (212, 312) form the trench structure in that the first trenches (204, 304) and the second trenches (212, 312) are arranged alternately, the first trenches (204, 304) are at least partly filled with a polycrystalline silicon, forming a gate terminal, as first doping region (206, 306) and the second trenches (212, 312) are filled with polycrystalline silicon as second doping region (213, 313), wherein the polycrystalline silicon in the first trench (204, 304) has a first conductivity type and the polycrystalline silicon in the second trench (206, 306) has a second conductivity type, wherein the first conductivity type and the second conductivity type are different, wherein the substrate comprises at least a source layer (207, 307), a body layer (203, 303), an epitaxial layer (202, 302) and a silicon layer (201, 301), wherein the source layer (207, 307) is arranged directly on the body layer (203, 303), the body layer (203, 303) is arranged directly on the epitaxial layer (202, 302), and the epitaxial layer (202, 302) is arranged on the silicon layer (201, 301), wherein the source layer (207, 307) comprises a third doping region, the epitaxial layer (202, 302) comprises a fifth doping region and the silicon layer (201, 301) comprises a sixth doping region, wherein the third doping region, the fifth doping region and the sixth doping region have the first conductivity type, and the body layer (203, 303) comprises a fourth doping region, wherein the fourth doping region has the second conductivity type, wherein the first trenches (204, 304) and the second trenches (212, 312) extend at least right into the epitaxial layer (202, 302), wherein an intermediate layer (314) is arranged between the epitaxial layer (202, 302) and the silicon layer (201, 301), said intermediate layer having a higher doping than the epitaxial layer (202, 302), wherein the intermediate layer (314) has a seventh doping region having the first conductivity type, wherein a direct contact of the second trenches (212, 312) and the intermediate layer (314) produces a p/n junction.

2. Power MOSFET (200, 300) according to Claim 1, **characterized in that** the second trenches (212, 312) extend at least right into the intermediate layer (314) .

3. Power MOSFET (200, 300) according to either of Claims 1 and 2, **characterized in that** the silicon layer (201, 301) is arranged on a first metal layer (211, 311), which functions as rear-side metallization.

4. Power MOSFET (200, 300) according to any of the preceding claims, **characterized in that** the first conductivity type corresponds to an n-type doping and the second conductivity type corresponds to a p-type doping.

5. Power MOSFET (200, 300) according to any of the preceding claims, **characterized in that** the second trenches (212, 312) have a greater width than the first trenches (204, 304).

6. Power MOSFET (200, 300) according to any of the preceding claims, **characterized in that** the second material comprises boron ions.

7. Power MOSFET (200, 300) according to Claim 6, **characterized in that** the concentration of the boron ions at the surface of the second trenches is greater than 10¹⁸ cm⁻³.

## Revendications

1. MOSFET de puissance (200, 300) comprenant un substrat qui présente une surface de substrat dans laquelle est incorporée une structure de tranchées, des premières tranchées (204, 304) dotées d'un oxyde de grille sur la surface de tranchée et des deuxièmes tranchées (212, 312) formant la structure de tranchées en ce que les premières tranchées (204, 304) et les deuxièmes tranchées (212, 312) sont disposées en alternance, les premières tranchées (204, 304) sont remplies au moins partiellement de silicium polycristallin formant une borne de grille comme première région de dopage (206, 306) et les deuxièmes tranchées (212, 312) sont remplies de silicium polycristallin comme deuxième région de dopage (213, 313), le silicium polycristallin dans la première tranchée (204, 304) présentant un premier type de conductivité, et le silicium polycristallin dans la deuxième tranchée (206, 306) présentant un deuxième type de conductivité, le premier type de conductivité et le deuxième type de conductivité étant différents, le substrat comprenant au moins une couche de source (207, 307), une couche de corps (203, 303), une couche épitaxiale (202, 302) et une couche de silicium (201, 301), la couche de source (207, 307) étant disposée directement sur la couche de corps (203, 303), la couche de corps (203, 303) étant disposée directement sur la couche épitaxiale (202, 302), et la couche épitaxiale (202, 302) étant disposée sur la couche de silicium (201, 301), la couche de source (207, 307) comprenant une troisième région de dopage, la couche épitaxiale (202, 302) comprenant une cinquième région de dopage, et la couche de silicium (201, 301) comprenant une sixième région de dopage, la troisième région de dopage, la cinquième région de dopage et la sixième région de dopage présentant le premier type de conductivité, et la couche de corps (203, 303) comprenant une quatrième région de dopage, la quatrième région de dopage présentant le deuxième type de conductivité, les premières tranchées (204, 304) et les deuxièmes tranchées (212, 312) s'étendant au moins jusque dans la couche épitaxiale (202, 302), dans lequel, entre la couche épitaxiale (202, 302) et la couche de silicium (201, 301), une couche intermédiaire (314) est disposée qui présente un dopage plus élevé que la couche épitaxiale (202, 302), la couche intermédiaire (314) présentant une septième région de dopage qui présente le premier type de conductivité, un contact direct des deuxièmes tranchées (212, 312) et de la couche intermédiaire (314) produisant une jonction p/n.

2. MOSFET de puissance (200, 300) selon la revendication 1, **caractérisé en ce que** les deuxièmes tranchées (212, 312) s'étendent au moins jusque dans la couche intermédiaire (314).

3. MOSFET de puissance (200, 300) selon l'une quelconque des revendications 1 et 2, **caractérisé en ce que** la couche de silicium (201, 301) est disposée sur une première couche de métal (211, 311) qui sert de métallisation de face arrière.

4. MOSFET de puissance (200, 300) selon l'une quelconque des revendications précédentes, **caractérisé en ce que** le premier type de conductivité correspond à un dopage n, et le deuxième type de conductivité correspond à un dopage p.

5. MOSFET de puissance (200, 300) selon l'une quelconque des revendications précédentes, **caractérisé en ce que** les deuxièmes tranchées (212, 312) présentent une largeur plus grande que les premières tranchées (204, 304) .

6. MOSFET de puissance (200, 300) selon l'une quelconque des revendications précédentes, **caractérisé en ce que** le premier matériau présente des ions de bore.

7. MOSFET de puissance (200, 300) selon la revendication 6, **caractérisé en ce que** la concentration en ions de bore à la surface des deuxièmes tranchées est supérieure à 10¹⁸ cm⁻³.
